# EUROPEAN PATENT APPLICATION

(11) **EP 4 376 573 A1**
(43) Date of publication of application: **29.05.2024**
(21) Application number: 21859354.9
(22) Date of filing: 04.08.2021
(51) Int. Cl.: H10K 59/00

(54) **DISPLAY PANEL AND DISPLAY APPARATUS**

(30) Priority: 20.07.2021 CN 202110817456
(71) Applicant: Wuhan China Star Optoelectronics Semiconductor Display Technology Co., Ltd., Wuhan, Hubei 430079 (CN)
(72) Inventor: ZHOU, Jing, Wuhan Hubei 430079 (CN)
(74) Representative: Murgitroyd & Company
(86) International application number: PCT/CN2021/110504
(87) International publication number: WO 2023/000387

(57) **Abstract**

The present application provides a display panel and a display device. A light shielding layer of the display panel is arranged on a light emitting side of a light emitting layer, and comprises openings corresponding to a light emitting area of the light emitting layer. By combining the light shielding layer with an anti-reflection layer, the present application achieves a function of a conventional polarizer. Therefore, three manufacturing steps for red, green, and blue color resists are omitted, which solves a problem that more manufacturing steps are required in conventional OLED display panels with POL-less technology.

## Description

### Technical Field

The present application relates to a field of display technology and in particular, to a display panel and a display device.

### Related Art

With the development of display technology, organic light-emitting diode (OLED) displays have advantages such as self-luminescence, wide viewing angles, wide color gamut, fast response speed, high luminous efficiency, low working voltage, thin thickness, being able to make large-sized flexible displays, and simple manufacturing processes. Therefore, the OLED displays are widely used in the fields of display, lighting, and smart wear. At present, in order to prevent components in OLED display panels from reflecting ambient light and affecting display quality, it is generally necessary to attach a polarizer with an anti-reflection function to a light emitting side of the OLED display panel. Although the display quality can be guaranteed this way, the polarizer causes a certain loss in an output light of the OLED display panel, which reduces display brightness of the OLED display panel. Also, a relatively thick thickness of the polarizer is not conducive to bending.

Accordingly, a polarizer-less (POL-less) technology that uses color filters to replace polarizers (POL) has emerged. The POL-less technology can increase a light output rate of the OLED display panel and reduce an overall thickness of the OLED display. The color filters are composed of red (R), green (G), and blue (B) color resists and black matrixes (BM). The red, green, and blue color resists are responsible for light output of the R/G/B sub-pixel units of the corresponding light-emitting units, while the BM is mainly responsible for preventing the panel from leaking light and for reducing reflectivity of the panel. However, the POL-less technology requires four manufacturing steps to produce the red, green, and blue color resists and the black matrixes, resulting in more manufacturing steps, and greatly affecting production yields and costs of the OLED display panels.

Therefore, there is a need to solve a problem that more manufacturing steps are required for conventional OLED display panels which adopt the POL-less technology.

### SUMMARY

The present application provides a display panel and a display device to solve a technical problem that more manufacturing steps are required for the conventional OLED display panels which adopt polarizer-less (POL-less) technology.

Accordingly, the present application provides technical solutions as follows.

The present application provides a display panel, comprising:
a substrate;
a light emitting layer disposed on one side of the substrate and comprising a first pixel emitting a first color, a second pixel emitting a second color, and a third pixel emitting a third color;
a light shielding layer disposed on one side of the light emitting layer away from the substrate, and comprising a first opening corresponding in position to the first pixel, a second opening corresponding in position to the second pixel, and a third opening corresponding in position to the third pixel; and
an anti-reflection layer disposed on one side of the light shielding layer away from the substrate and covering the first opening, the second opening, and the third opening, wherein light transmittance of the anti-reflection layer ranges from 42 % to 90%

In the display panel according to one embodiment of the present application, the anti-reflection layer comprises an optically clear adhesive and a light absorption factor doped in the optically clear adhesive.

In the display panel according to one embodiment of the present application, the light absorption factor comprises a black pigment.

In the display panel according to one embodiment of the present application, the anti-reflection layer further comprises transparent light-scattering particles.

In the display panel according to one embodiment of the present application, a particle size of the transparent light-scattering particles is in a range of 400 nanometers to 1000 nanometers, and a concentration of the transparent light-scattering particles is in a range of 5% to 20%.

In the display panel according to one embodiment of the present application, the light absorption factor comprises black light-scattering particles.

In the display panel according to one embodiment of the present application, a particle size of the black light-scattering particles is in a range of 400 nm to 1000 nm, and a concentration of the black light-scattering particles is in a range of 5% to 20%.

In the display panel according to one embodiment of the present application, the anti-reflection layer has light transmittance of 60%.

In the display panel according to one embodiment of the present application, the anti-reflection layer has a thickness ranging from 20 micrometers to 100 micrometers.

In the display panel according to one embodiment of the present application, a protective layer is disposed between the light shielding layer and the anti-reflection layer; the protective layer covers the light shielding layer and fills the first opening, the second opening, and the third opening; and the anti-reflection layer covers the protective layer.

In the display panel according to one embodiment of the present application, light transmittance of the protective layer is greater than the light transmittance of the anti-reflection layer.

The present application also provides a display device, comprising the display panel of one of the foregoing embodiments and a circuit board disposed on a non-light-emitting side of the display panel.

Advantages of the present application:
The light shielding layer in the display panel and the display device of the present application is arranged on a light emitting side of the light emitting layer, and is provided with openings corresponding to a light emitting area of the light emitting layer. The anti-reflection layer is arranged on an entire surface of the light shielding layer away from the substrate. Light transmittance of the anti-reflection layer ranges from 42% to 90%, so as to get a balance between light output efficiency and an anti-reflection capability of the display panel. By combining the light shielding layer with the anti-reflection layer, three manufacturing steps for red, green, and blue resists in conventional POL-less technology are omitted from the present application. Accordingly, the present application solves a problem that more manufacturing steps are required in conventional OLED display panels with the POL-less technology.

### BRIEF DESCRIPTION OF THE DRAWINGS

In order to more clearly illustrate the embodiments of the present disclosure or related art, figures which will be described in the embodiments are briefly introduced hereinafter. It is obvious that the drawings are merely for the purposes of illustrating some embodiments of the present disclosure, and a person having ordinary skill in this field can obtain other figures according to these figures without inventive work.
FIG. 1 is a schematic cross-sectional structural view of a display panel according to one embodiment of the present application.
FIG. 2 is a schematic partial cross-sectional structural view of a display panel body according to one embodiment of the present application.
FIG. 3 is another schematic cross-sectional structural view of the display panel according to one embodiment of the present application.
FIG. 4 is still another schematic cross-sectional structural view of the display panel according to one embodiment of the present application.
FIG. 5 is yet another schematic cross-sectional structural view of the display panel according to one embodiment of the present application.

### DETAILED DESCRIPTION

The present application is described below with reference to accompanying drawings in conjunction with specific embodiments. Directional terms mentioned in the present application, such as "up", "down", "front", "rear", "left", "right", "inner", "outer", and "side", are for illustrative purposes based on the accompanying drawings. Therefore, the directional terms are used to illustrate and understand the present application, rather than to limit the present application. In the drawings, elements with similar structures are denoted by the same reference numerals. In the accompanying drawings, for clear understanding and ease of description, thicknesses of some layers and regions are exaggerated. That is to say, a size and a thickness of each component shown in the drawings are not to scale, and the present application is not limited in this regard.

In view of a problem that manufacturing steps are increased when conventional OLED display panels use polarizer-less (POL-less) technology, the inventor of the present application found in research that, by skipping three manufacturing steps for red, green, and blue color resists, the problem that the POL-less technology increases manufacturing steps can be solved. However, after simply removing the red, green, and blue color resists, no photoresists can be used for reflectivity reduction, thus causing reflectivity of the OLED display panel to rise sharply, lacking functions of a polarizer, and seriously affecting display quality of the OLED display panel.

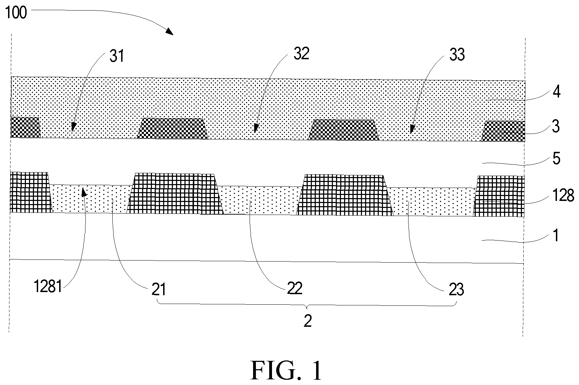

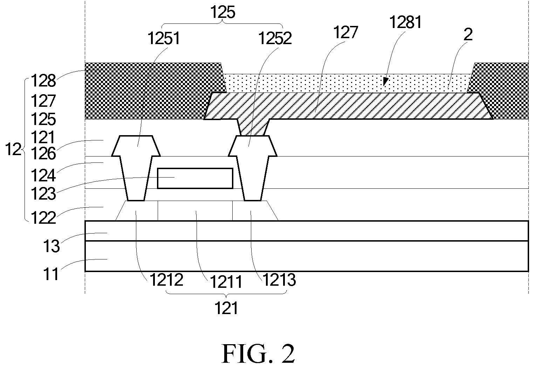

Accordingly, the inventor of the present application creates a display panel and a display device to solve the above-mentioned problems:
Please refer to FIGs. 1 and 2 in combination. FIG. 1 is a schematic cross-sectional structural view illustrating a display panel according to one embodiment of the present application. FIG. 2 is a schematic cross-sectional structural view of a substrate according to one embodiment of the present application. The display panel 100 comprises a substrate 1, a light emitting layer 2, a light shielding layer 3, and an anti-reflection layer 4. The light emitting layer 2 is disposed on one side of the substrate 1, and comprises a first pixel 21 that emits a first color, a second pixel 22 that emits a second color, and a third pixel 23 that emits a third color.

The first pixel 21, the second pixel 22, and the third pixel 23 are respectively formed of luminescent materials of different colors, and the luminescent materials of different colors emit light of different colors. For example, if the first pixel 21 is formed of a red light-emitting material, the first pixel 21 emits red light; if the second pixel 22 is formed of a green light-emitting material, the second pixel 22 emits green light; and if the third pixel 23 is formed of a blue light-emitting material, and the third pixel 23 emits blue light.

The adjacent first pixel 21, second pixel 22, and third pixel 23 together constitute a pixel unit. The first pixel 21, the second pixel 22, and the third pixel 23 emit red light, green light, and blue light, respectively, so that the pixel unit can display various colors. At the same time, the display panel 100 comprises multiple pixel units, so the display panel 100 can display different colors, so as to realize a full-color display function of the display panel 100.

The light shielding layer 3 is disposed on one side of the light emitting layer 2 away from the substrate 1, and comprises a first opening 31 corresponding in position to the first pixel 21, a second opening 32 corresponding in position to the second pixel 22, and a third opening 33 corresponding in position to the third pixel 23. That is to say, the light shielding layer 3 is disposed on a light emitting side of the light emitting layer 2, and the openings of the light shielding layer 3 are defined corresponding to a light emitting area of the light emitting layer 2. The openings are used to allow light emitted by the light emitting layer to pass through.

The anti-reflection layer 4 is disposed on one side of the light shielding layer 3 away from the substrate 1 and covers the first opening 31, the second opening 32 and the third opening 33. An orthographic projection of the anti-reflection layer 4 projected on the substrate 1 covers orthographic projections of the light shielding layer 3, the first opening 31, the second opening 32, and the third opening 33 projected on the substrate 1. The anti-reflection layer 4 is used to lower reflectivity of the display panel 100. Light transmittance of the anti-reflection layer 4 ranges from 42% to 90%. This way, functions of a conventional polarizer can be achieved by a combination of the light shielding layer 3 and the anti-reflection layer 4, thereby omitting a need for three manufacturing steps for red, green, and blue color resists in the conventional POL-less technology.

A film structure of each functional layer in the display panel 100 is described in detail below:
Specifically, the substrate 1 comprises a substrate 11 and a driving circuit layer 12 disposed on the substrate 11. Optionally, the substrate 11 can be a rigid substrate or a flexible substrate. When the substrate 11 is the rigid substrate, it can comprise a glass substrate or other rigid substrate. When the substrate 11 is the flexible substrate, it can comprise a polyimide (PI) film, an ultra-thin glass film, or other flexible substrate. The flexible display panel 100 can be fabricated by using the flexible substrate as a substrate, so as to achieve special properties such as bending or rolling up the display panel 100.

Optionally, a buffer layer 13 can be disposed between the substrate 11 and the driving circuit layer 12. A material of the buffer layer 13 can comprise silicon oxide (SiOₓ), silicon nitride (SiNₓ), silicon oxynitride (SiON), and other inorganic materials. The buffer layer 13 can prevent undesirable impurities or pollutants (such as moisture and oxygen) from diffusing from the substrate 11 into components that can be damaged by these impurities or pollutants. At the same time, the buffer layer 13 also provides a flat top surface.

The driving circuit layer 12 comprises an active layer 121, a gate insulating layer 122, a gate 123, an interlayer insulating layer 124, a source/drain layer 125, a planarization layer 126, and a pixel definition layer 128 which are sequentially stacked on the buffer layer 13. The active layer 121 comprises a channel region 1211 and comprises a source region 1212, a drain region 1213 located on two sides of the channel region 1211. The gate 123 is arranged corresponding to the channel region 1211.

The source/drain layer 125 comprises a source 1251 and a drain 1252. The source 1251 and the drain 1252 are connected to the source region 1212 and the drain region 1213 of the active layer 121 through via holes of the interlayer insulating layer 124 and the gate insulating layer 122. The planarization layer 126 is disposed on the source/drain layer 125 and the interlayer insulating layer 124 to provide a flat surface for the driving circuit layer 12. The pixel electrode 127 is disposed on the surface of the planarization layer 126 and is connected to the source 1251 or the drain 1252 through a via hole of the planarization layer 126. As shown in FIG. 2, the pixel electrode 127 is connected to the drain 1252.

The pixel definition layer 128 is disposed on the pixel electrode 127 and the planarization layer 126. The pixel definition layer 128 is patterned to form a plurality of pixel openings 1281. The pixel opening 1281 exposes a portion of the pixel electrode 127 to thereby define an area for arranging the light emitting layer 2. An area of the pixel opening 1281 is also a light emitting area of the light emitting layer 2, and the pixel opening 1281 is arranged corresponding to the corresponding opening of the light shielding layer 3. The light emitting layer 2 is formed of a light emitting material imprinted in the pixel opening 1281 of the pixel definition layer 128. Light emitting materials of different colors form the light emitting layer 2 of different colors. It should be noted that a structure of the driving circuit layer 12 of the present application is not limited to the structure illustrated in the present embodiment. The driving circuit layer 12 of the present application can also comprise more or less film layers, and a positional relationship of the film layers is not limited to the present embodiment as disclosed. For example, the gate 123 can also be located under the active layer 121 to form a bottom gate structure.

In addition, in order to realize light emission of the light emitting layer 2, the display panel 100 further comprises a cathode (not illustrated) disposed on one side of the light emitting layer 2 away from the pixel electrode 127, the cathode covers the light emitting layer 2 and the pixel definition layer 128, and the light emitting layer 2 emits light due to cooperation of the driving circuit layer 12 and the cathode.

Optionally, the pixel electrode 127 can be a transparent electrode or a reflective electrode. If the pixel electrode 127 is a transparent electrode, the pixel electrode 127 can be made of, for example, indium tin oxide (ITO), indium zinc oxide (IZO), ZnO, or In₂O₃. If the pixel electrode 127 is the reflective electrode, the pixel electrode 127 can comprise, for example, a reflective layer formed of Ag, Mg, Al, Pt, Pd, Au, Ni, Nd, Ir, Cr, or a combination thereof, and a layer formed of ITO, IZO, ZnO, or In₂O₃. However, the pixel electrode 127 is not limited in this regard, and the pixel electrode 127 can be formed of various materials, and can also be formed into a single-layer or multi-layer structure.

It should be noted that whether the pixel electrode 127 is the transparent electrode or the reflective electrode depends on a light emitting direction of the display panel 100. When the display panel 100 adopts a top emission design, the pixel electrode 127 can be the transparent electrode or the reflective electrode. Certainly, using the reflective electrode can improve a utilization rate of light emitted by the light emitting layer 2. When the display panel 100 adopts a bottom emission design, the pixel electrode 127 is the transparent electrode to increase the light transmittance. In the present embodiment, the display panel 100 adopts the top emission design as an example. The light emitting side of the light emitting layer 2 is one side of the light emitting layer 2 away from the driving circuit layer 12. Accordingly, in order to improve the light transmittance, the cathode needs to be formed of a transparent conductive material. For example, the cathode can be formed of transparent conductive oxide (TCO) such as ITO, IZO, ZnO, or In₂O₃.

Optionally, a hole injection layer (HIL) and a hole transport layer (HTL) can be disposed between the light emitting layer 2 and the pixel electrode 127; and an electron injection layer (EIL) and electron transport layer (ETL) can be disposed between the light emitting layer 2 and the cathode. The hole injection layer receives holes transmitted by the pixel electrode 127, the holes are transmitted to the light emitting layer 2 through the hole transport layer, the electron injection layer receives electrons transmitted by the cathode, and the electrons are transmitted to the light emitting layer 2 through the electron transport layer. Holes and electrons are combined in the light emitting layer 2 to generate excitons, and the excitons transition from an excited state to a ground state to release energy and emit light.

Further, in order to protect the light emitting layer 2 and prevent moisture and oxygen from entering and causing the light emitting layer 2 to fail, the display panel 100 further comprises an encapsulation layer 5 located between the cathode and the light shielding layer 3. Specifically, the encapsulation layer 5 covers the cathode.

Optionally, the encapsulation layer 5 can be thin film encapsulation. For example, the encapsulation layer 5 can be a laminated structure formed by successively stacking three films of a first inorganic encapsulation layer, an organic encapsulation layer, and a second inorganic encapsulation layer, or can be a laminated structure consisting of more than three films. Materials of the first inorganic encapsulation layer and the second inorganic encapsulation layer comprise one or a combination of inorganic materials such as silicon oxide, silicon nitride, and silicon oxynitride. The first inorganic encapsulation layer and the second inorganic encapsulation layer can be deposited on the cathode by a deposition process such as chemical vapor deposition (CVD), physical vapor deposition (PVD), or atomic layer deposition (ALD). A material of the organic encapsulation layer comprises one or more of organic materials such as epoxy series and acrylic series. The organic encapsulation layer can be coated on the first inorganic encapsulation layer by one of coating processes such as ink jet printing (IJP) and spray coating.

The light shielding layer 3 is disposed on the light emitting side of the light emitting layer 2. Specifically, the light shielding layer 3 is disposed on the encapsulation layer 5, and the light shielding layer 3 is provided with openings (including the first opening 31, the second opening 32, and the third opening 33) defined corresponding to a light emitting area of the display panel 100, so that the light emitted by the light emitting layer 2 can be emitted through the openings. Optionally, a size of each opening of the light shielding layer 3 is greater than or equal to a size of each of the pixel openings 1281 of the pixel definition layer 128, so that the orthographic projection of each opening of the light shielding layer 3 projected on the substrate 11 completely covers an orthographic projection of a corresponding one of the pixel openings 1281 projected on the substrate 11. Such configuration is more favorable for the light emitting layer 2 to emit light through the openings.

Because the openings are defined in the light shielding layer 3 corresponding to the light emitting area, the light shielding layer 3 corresponds in position to a non-light-emitting area of the display panel 100. The non-light-emitting area of the display panel 100 is usually for placing a display circuit consisting of various metal lines. Accordingly, the light shielding layer 3 can shield the metal lines in the non-light-emitting area, and prevent external light entering the display panel 100 from getting reflected by the metal lines and consequently raising the reflectivity of the display panel 100. Thus, the reflectivity of the display panel 100 is lowered. The external light refers to ambient interference light other than the light emitted by the light emitting layer 2.

Optionally, a material of the light shielding layer 3 comprises materials with light-shielding properties such as black matrix (BM). The black matrix has excellent light-shielding properties and is easy to produce.

The anti-reflection layer 4 is disposed on one side of the light shielding layer 3 away from the encapsulation layer 5. An orthographic projection of the anti-reflection layer 4 projected on the substrate 1 covers the orthographic projection of the light shielding layer 3 and the orthographic projections of the openings in the light-shielding layer 3 projected on the substrate 1. Moreover, light transmittance of the anti-reflection layer 4 ranges from 42% to 90%. The anti-reflection layer 4 with the predetermined light transmittance is arranged corresponding to the openings of the light shielding layer 3, so that the anti-reflection layer 4 can block a portion of the external light from entering the display panel 100 through the openings of the light shielding layer 3 and getting reflected by metal electrodes such as the cathode and/or the pixel electrode 127 in the display panel 100. As a result, the reflectivity of the display panel 100 can be lowered.

Specifically, the anti-reflection layer 4 comprises an optically clear adhesive (OCA) and a light absorption factor doped in the OCA. The light absorption factor comprises black pigments, carbon black particles, black dyes, and other black materials with light absorption properties. The black pigment and other light absorption factors are doped into the OCA to form the black optical adhesive which serves as the anti-reflection layer 4 to reduce light transmittance of the OCA, so that the anti-reflection layer 4 with the predetermined light transmittance can be obtained. The predetermined light transmittance ranges from 42% to 90%, and a thickness of the anti-reflection layer 4 ranges from 20 micrometers to 100 micrometers (microns).

The anti-reflection layer 4 can block a portion of the external light from entering the substrate 1, thereby lowering the reflectivity of the display panel 100. However, the anti-reflection layer 4 also blocks a portion of the light emitted by the light-emitting layer 2, which reduces light emitting efficiency of the light emitting layer 2. In order to get a balance between an anti-reflection property of the anti-reflection layer 4 and light output efficiency, the light transmittance of the anti-reflection layer 4 is set to between 42% and 90%. Preferably, the light transmittance can be set to about 60% to obtain better results.

In addition, the display panel 100 further comprises a protective cover plate. The protective cover plate can be a glass cover, etc., for protecting the display panel 100. The protective cover plate is attached to the light shielding layer 3 through the anti-reflection layer 4. In conventional OLED display panels, an OCA is already used to bond a protective cover plate to a polarizer. Since the anti-reflection layer 4 of the present application is formed by doping the light absorption factor into the OCA, the anti-reflection layer 4 has adhesive functions and easy deformation characteristics of the conventional OCA. As such, the anti-reflection layer 4 can be used to bond the protective cover plate to the light shielding layer 3. Further, when the anti-reflection layer 4 is attached to the light shielding layer 3, the anti-reflection layer 4 deforms on an uneven surface to fill the openings of the light shielding layer 3.

Compared with conventional OLED display panels using polarizer-less (POL-less) technology, in the display panel 100 of the present application, because the light shielding layer 3 and the anti-reflection layer 4 are combined to realize the function of the conventional polarizer, so there is no need to arrange red, green, and blue color resists, and therefore three manufacturing steps can be omitted. At the same time, by providing the anti-reflection layer 4 with the predetermined light transmittance, the reflectivity of the display panel 100 can be lowered without excessively affecting luminous efficiency of the light emitting layer 2. Moreover, because the anti-reflective layer 4 also possesses some properties of the conventional OCA, the protective cover plate and the light shielding layer 3 can be bonded together without increasing a film thickness of the display panel 100.

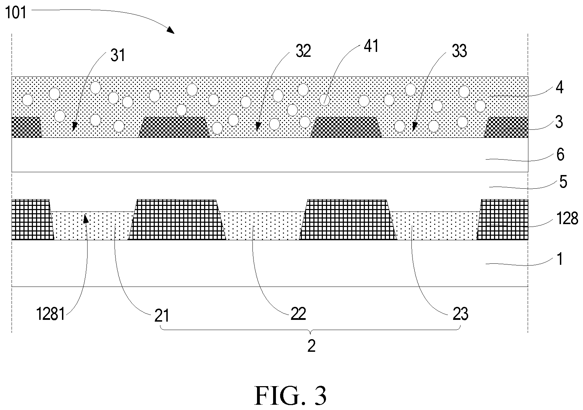

One embodiment is shown in FIG. 3. FIG. 3 is another schematic cross-sectional structure of a display panel according to one embodiment of the present application. The present embodiment is different from the above-mentioned embodiment in that the anti-reflection layer 4 also comprises transparent light-scattering particles 41. In other words, the anti-reflection layer 4 is formed by doping a light absorption factor such as black pigments as well as doping transparent light-scattering particles 41 into the OCA. This way, due to the addition of the transparent light-scattering particles 41 which can scatter light, the anti-reflection layer 4 can lower the reflectivity of the display panel 100 while widening a range of light output viewing angles of the light-emitting layer 2.

Specifically, the transparent light-scattering particles 41 comprise at least one of transparent materials such as TiO₂, ZrO₂, ZnO₂, Al₂O₃ and the like. A particle size of the transparent light-scattering particles 41 is related to a light dispersion manner of the material and a manufacturing process. If the particle size of the transparent light-scattering particles 41 is too large, it is not conducive to scattering of the transparent light-scattering particles 41, so the transparent light-scattering particles 41 are deposited. If the particle size of the transparent light-scattering particles 41 is too small, a scattering effect is affected. Therefore, the particle size of the transparent light-scattering particles 41 of the present application is set in a range of 400 nanometers to 1000 nanometers.

At the same time, a concentration of the transparent light-scattering particles 41 is also related to the light dispersion manner of the material and the manufacturing process. If the concentration of the transparent light-scattering particles 41 is too low, a light scattering effect is poor. If the concentration of the transparent light-scattering particles 41 is too high, it is easy to cause uneven scattering of the transparent light-scattering particles 41 if the transparent light-scattering particles 41 aggregate. A concentration range of the transparent light-scattering particles 41 in the present application is between 5% and 20%.

In addition, the display panel 101 of the present embodiment also has a touch function. In order to realize the touch function, a direct on-cell touch (DOT) solution can be used, in which a touch function layer 6 is directly produced on the encapsulation layer 5, the light shielding layer 3 is disposed on the touch function layer 6, and the anti-reflection layer 4 is still disposed on the light shielding layer 3. Compared with a touch solution with an external touch panel, the DOT solution can reduce a thickness of the display panel 101 to achieve high-level integration of the display panel 101. For other descriptions, reference can be made to the above-mentioned embodiments, and related descriptions are not repeated here.

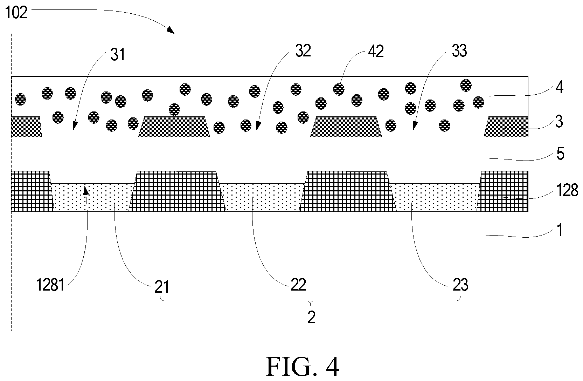

One embodiment is shown in FIG. 4. FIG. 4 is another schematic cross-sectional structural view of the display panel according to one embodiment of the present application. The present embodiment is different from the foregoing embodiments in that the anti-reflection layer 4 comprises an OCA and a light absorption factor doped in the OCA, and the light absorption factor comprises black light-scattering particles 42. The black light-scattering particles 42 can absorb and scatter light, so the anti-reflection layer 4 formed by doping the black light-scattering particles 42 in the OCA also can absorb and scatter light. By adjusting a doping concentration of the black light-scattering particles 42, the anti-reflection layer 4 can have the predetermined light transmittance, so as to reduce the reflectivity of the display panel 102.

Specifically, the black light-scattering particles 42 can be light-scattering particles with light absorption properties such as soda borosilicate glass doped with cobalt-chromium-copper composite ions, and high-molecular polymers doped with carbon black particles, black pigments, or black dyes. A particle size of the black light-scattering particles 42 is related to the light dispersion manner of the material and the manufacturing process. If the particle size of the black light-scattering particles 42 is too large, it is not conducive to the scattering of the black light-scattering particles 42, so the black light-scattering particles 42 are deposited. If the particle size of the black light-scattering particles 42 is too small, the scattering effect is affected. Therefore, the particle size of the black light-scattering particles 42 of the present application is set to be in a range of 400 nanometers to 1000 nanometers.

At the same time, the concentration of the black light-scattering particles 42 is also related to the light dispersion manner of the material and the manufacturing process. If the concentration of the black light-scattering particles 42 is too low, the light scattering effect is poor. If the concentration of the black light-scattering particles 42 is too high, it is easy to cause uneven light dispersion if the black light-scattering particles 42 aggregate. Moreover, the concentration of the black scattering particles 42 directly decides the light transmittance of the anti-reflection layer 4. Therefore, in order have the predetermined light transmittance of the anti-reflection layer 4, and to ensure the light scattering effect of the black light-scattering particles 42. The concentration of the black light-scattering particles 42 in the present application is set in a range of 5% to 20%.

In the present embodiment, the black scattering particles 42 are doped in the OCA to form the anti-reflection layer 4 with the predetermined light transmittance. The anti-reflection layer 4 can reduce the reflectivity of the display panel 102 without affecting the light output efficiency of the light emitting layer 2, and can also widen a range of the light output viewing angles of the light emitting layer 2. For other descriptions, reference can be made to the above-mentioned embodiment, and related descriptions are omitted herein for brevity.

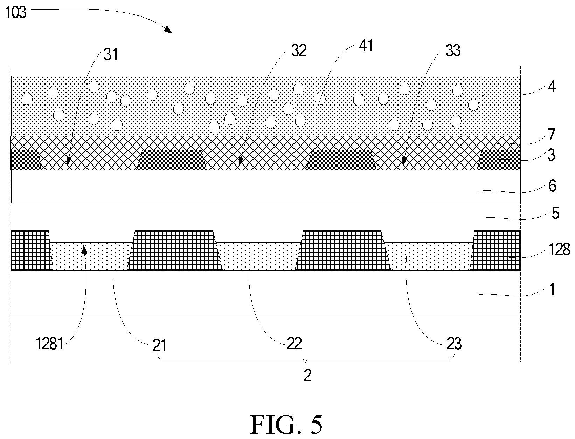

One embodiment is shown in FIG. 5, which is still another cross-sectional structural view of the display panel of the present application. The present embodiment is different from the above-mentioned embodiment in that a protective layer 7 is disposed between the light shielding layer 3 and the anti-reflection layer 4 of the display panel 103. The protective layer 7 covers the light-shielding layer 3 and fills in the first opening 31, the second opening 32, and the third opening 33 of the light shielding layer 3. The anti-reflection layer covers the protective layer. A material of the protective layer 7 comprises an over coat (OC) material, such as a photosensitive resin film. Light transmittance of the protective layer 7 is greater than the light transmittance of the anti-reflection layer 4.

The OC material is coated on an entire surface of the light shielding layer 3 and is filled in the openings of the light shielding layer 3 to form a film layer with a flat top surface, so that there are no defects such as bubbles when the anti-reflection layer 4 is attached to the protective layer 7. At the same time, the protective layer 7 can also protect the light shielding layer 3 and the touch function layer 6 to prevent peeling. In addition, the protective layer 7 can also isolate the anti-reflective layer 4 and the light shielding layer 3, so as to prevent the light shielding layer 3 and the anti-reflection layer 4 from producing reactions due to making contacts under environmental reliability tests (such as high temperature and high humidity). Moreover, the light transmittance of the protective layer 7 is greater than the light transmittance of the anti-reflection layer 4, so that the light output efficiency of the light emitting layer 2 is not affected. For other descriptions, please refer to the above-mentioned embodiment, so related descriptions are not repeated here.

The present application also provides a display device, which comprises the display panel of one of the foregoing embodiments, and a circuit board disposed on the non-light-emitting side of the display panel.

According to the above embodiment, it can be known that:
The present application provides a display panel and a display device. The display panel comprises a substrate, a light emitting layer, a light shielding layer, and an anti-reflection layer. The light shielding layer is arranged on a light emitting side of the light emitting layer, and a plurality of openings are defined corresponding to a light emitting area. The anti-reflection layer is arranged on one side of the light shielding layer away from the substrate. The anti-reflection layer is formed by doping a light absorption factor in an optically clear adhesive, such that light transmittance of the anti-reflection layer ranges from 42% to 90% to balance light output efficiency and an anti-reflection property of the display panel. By combining the light shielding layer with the anti-reflection layer, the present application provides a function of a conventional polarizer, thus eliminating three manufacturing steps for red, green, and blue color resists in the conventional POL-less technology, so as to solve a problem that more manufacturing steps are required for conventional OLED display panels with the POL-less technology.

In the above-mentioned embodiments, the description of each embodiment has its own emphasis. For those that are not described in detail in one embodiment, reference can be made to related descriptions of other embodiments.

The present application is described in detail above. Specific examples are used in the present disclosure to explain working principles and embodiments of the present application. The descriptions of the above embodiments are only used for ease of understanding the technical solutions and main ideas of the present application. Those of ordinary skill in the art can still modify the technical solutions or equivalently replace some of the technical features in the embodiments. Such modifications or replacements are within the protection scope of the embodiments of the present application.

## Claims

1. A display panel, comprising:
a substrate;
a light emitting layer disposed on one side of the substrate and comprising a first pixel emitting a first color, a second pixel emitting a second color, and a third pixel emitting a third color;
a light shielding layer disposed on one side of the light emitting layer away from the substrate, and comprising a first opening corresponding in position to the first pixel, a second opening corresponding in position to the second pixel, and a third opening corresponding in position to the third pixel; and
an anti-reflection layer disposed on one side of the light shielding layer away from the substrate and covering the first opening, the second opening, and the third opening, wherein light transmittance of the anti-reflection layer ranges from 42 % to 90%.

2. The display panel according to claim 1, wherein the anti-reflection layer comprises an optically clear adhesive and a light absorption factor doped in the optically clear adhesive.

3. The display panel according to claim 2, wherein the light absorption factor comprises a black pigment.

4. The display panel according to claim 3, wherein the anti-reflection layer further comprises transparent light-scattering particles.

5. The display panel according to claim 4, wherein a particle size of the transparent light-scattering particles is in a range of 400 nanometers to 1000 nanometers, and a concentration of the transparent light-scattering particles is in a range of 5% to 20%.

6. The display panel according to claim 2, wherein the light absorption factor comprises black light-scattering particles.

7. The display panel according to claim 6, wherein a particle size of the black light-scattering particles is in a range of 400 nm to 1000 nm, and a concentration of the black light-scattering particles is in a range of 5% to 20%.

8. The display panel according to claim 1, wherein the anti-reflection layer has light transmittance of 60%.

9. The display panel according to claim 1, wherein the anti-reflection layer has a thickness ranging from 20 micrometers to 100 micrometers.

10. The display panel according to claim 1, wherein a protective layer is disposed between the light shielding layer and the anti-reflection layer; the protective layer covers the light shielding layer and fills the first opening, the second opening, and the third opening; and the anti-reflection layer covers the protective layer.

11. The display panel according to claim 10, wherein light transmittance of the protective layer is greater than the light transmittance of the anti-reflection layer.

12. A display device, comprising a display panel and a circuit board disposed on a non-light-emitting side of the display panel, the display panel comprising:
a substrate
a light emitting layer disposed on one side of the substrate and comprising a first pixel emitting a first color, a second pixel emitting a second color, and a third pixel emitting a third color;
a light shielding layer disposed on one side of the light emitting layer away from the substrate, and comprising a first opening corresponding in position to the first pixel, a second opening corresponding in position to the second pixel, and a third opening corresponding in position to the third pixel; and
an anti-reflection layer disposed on one side of the light shielding layer away from the substrate and covering the first opening, the second opening, and the third opening, wherein light transmittance of the anti-reflection layer ranges from 42 % to 90%.

13. The display device according to claim 12, wherein the anti-reflection layer comprises an optically clear adhesive and a light absorption factor doped in the optically clear adhesive.

14. The display device according to claim 13, wherein the light absorption factor comprises a black pigment.

15. The display device according to claim 14, wherein the anti-reflection layer further comprises transparent light-scattering particles.

16. The display device according to claim 15, wherein a particle size of the transparent light-scattering particles is in a range of 400 nanometers to 1000 nanometers, and a concentration of the transparent light-scattering particles is in a range of 5% to 20%.

17. The display device according to claim 13, wherein the light absorption factor comprises black light-scattering particles.

18. The display device according to claim 17, wherein a particle size of the black light-scattering particles is in a range of 400 nanometers to 1000 nanometers, and a concentration of the black light-scattering particles is in a range of 5% to 20%.

19. The display device according to claim 12, wherein a protective layer is disposed between the light shielding layer and the anti-reflection layer; the protective layer covers the light shielding layer and fills the first opening, the second opening, and the third opening; and the anti-reflection layer covers the protective layer.

20. The display device according to claim 19, wherein light transmittance of the protective layer is greater than the light transmittance of the anti-reflection layer.
